Europäisches Patentamt

European Patent Office

Office européen des brevets

(19)

(11) **EP 0 468 691 B1**

(12) # EUROPEAN PATENT SPECIFICATION

(45) Date of publication and mention
of the grant of the patent:
**08.10.1997 Bulletin 1997/41**

(51) Int Cl.6: **H01L 33/00**, H01L 31/0352,
H01S 3/19

(21) Application number: **91306495.2**

(22) Date of filing: **17.07.1991**

(54) **Optical semiconductor device for emitting or sensing light of desired wavelength**

Optische Halbleitervorrichtung zur Emission oder Detektion von Licht mit einer gewünschten Wellenlänge

Dispositif optique à semi-conducteur pour émettre ou détecter la mumière d'une longueur d'onde désirée

(84) Designated Contracting States:
DE FR GB

(30) Priority: **17.07.1990 JP 187241/90**

(43) Date of publication of application:
**29.01.1992 Bulletin 1992/05**

(73) Proprietor: **KABUSHIKI KAISHA TOSHIBA**
**Kawasaki-shi, Kanagawa-ken 210 (JP)**

(72) Inventor: **Natori, Kenji,**
**c/o Intellectual Property Div.**
**Minato-ku, Tokyo 105 (JP)**

(74) Representative: **Freed, Arthur Woolf et al**
**MARKS & CLERK,**
**57-60 Lincoln's Inn Fields**
**London WC2A 3LS (GB)**

(56) References cited:
• **PATENT ABSTRACTS OF JAPAN, vol. 13, no. 106 (E-726) 14 March 1989; & JP-A-63 278 290**
• **IEEE JOURNAL OF QUANTUM ELECTRONICS, vol. 25, no. 1, January 1989, New York US, pp. 12-19; KANG L. WANG et al.: 'Theory and applications of band-aligned superlattices'**
• **PATENT ABSTRACTS OF JAPAN, vol. 13, no. 103 (E-725) 10 March 1989; & JP-A-63 276 289**
• **PATENT ABSTRACTS OF JAPAN, vol. 12, no. 232 (E-628) 30 June 1988; & JP-A-63 021 891**
• **JOURNAL OF APPLIED PHYSICS, vol. 63, no. 8, 15 April 1988, New York US, pp. 2856-2858; H.C. LIU : 'A novel superlattice infrared source'**

**Description**

The present invention relates generally to optical semiconductor devices, and more particularly to a semiconductor laser device capable of either emitting or sensing light at selected wavelength.

In recent years, semiconductor laser devices have been widely used in the art as optical devices for either emitting or sensing light of selected wavelength. physical light-emission mechanism of currently available semiconductor laser devices is principally based on the forward-biasing operations at p-n junctions.

In the band structure of these lasers, free electrons are excited into the quantum well of the conduction band, while holes are left in that of the valence band. Such a condition is generally known as the "inverted distribution" condition. Under this condition, when an electron drops from the conduction band toward the valence band, stimulated light may be emitted at a corresponding intensity of radiation. This leads to laser light oscillation. The optical energy of laser is normally greater than the value of a band gap between the valence band and the conduction band of the laser device; for example, it may measure 1.5 electron-volts (eV).

The conventional semiconductor laser devices suffer from their limited changeability in the oscillation wavelength thereof. This comes from the fact that the wavelength of exciting light is unconditionally determined by the band gap value of an active layer employed therein. This value is essentially inherent in a semiconductor material being used. Thus, we can say that, once a semiconductor material is chosen, the oscillation wavelength will be determined regardless of other physical parameters. This suggests the impossibility of laser oscillation at different wavelengths while using the same semiconductive material. We do not have, for several reasons, so large selection of semiconductor materials to be used for the laser device; therefore, it has been long considered impossible among those skilled in the art to accomplish emission or sense of specific light at desired wavelength—in particular, at the long-wavelength ranging from far-infrared radiation to millimeter-wave radiation—by employing currently available semiconductor materials.

It is therefore an object of the present invention to provide a novel optical device capable of emitting light at desired wavelength.

It is another object of this invention to provide a new type of optical semiconductor device that can emit or sense light at any desired wavelength without using any special semiconductor material.

The present invention now provides an optical device having a substrate, comprising a quantum well layer arranged on said substrate, said device including both a first section (I) having a first region of said quantum well layer and also a second section (II) arranged adjacent to said first section and having a second region of said quantum well layer, which second region is different in physical shape from first region, and bias means comprising first and second electrodes for applying a bias between said first and second sections (I, II), characterised in that said difference in physical shape being such that the ground-state level of one of the first and second sections (I, II) is substantially equal to an excitation level of the other of said first and second sections (I, II), and the first and second electrodes of said bias means are respectively formed on said first region and said second region, respectively, to cause transfer of carriers between the first and second sections within said quantum well layer, thereby to effect emission or detection of light.

A semiconductor laser having a plurality of quantum well active layers with different structures of energy levels is described in JP-A-63 276 289. In this device, however, currents are independently injected into said plurality of active layers.

Here, it can be noted that use of a superlattice structure as an infrared source is disclosed in J. Appl. Phys, 63, No. 8, 1988, 2856-2858. JP-A-63 021 891 discloses another infrared source in which an electric field is applied perpendicularly to a quantum well having a plurality of quantum levels in the conduction band. A discussion of electron flow transmission coefficients in a superlattice is contained in IEEE J. Qant. Electron, 25, No. 1, 1989, 12-19.

The foregoing and other objects, features, and advantages of the invention will become apparent from the following more particular description of preferred embodiments of the invention, as illustrated in the accompanying drawings.

This invention can be more fully understood from the following detailed description when taken in conjunction with the accompanying drawings, in which:

FIG. 1 is a diagram showing a sectional view of a semiconductor laser device in accordance with one preferred embodiment of the present invention.

FIG. 2 is a schematical plan view of the laser device shown in FIG. 1.

FIG. 3 is a band gap diagram of the laser device of FIGS. 1 and 2.

FIG. 4 is a graph illustrating plots of energy (E) versus wave vector (k) for free electron in a photoemission mode of the laser device of FIGS. 1 and 2.

FIG. 5 is a graph illustrating plots of energy versus wave vector for free electron in a photodetection mode of the device shown in FIGS. 1 and 2.

FIG. 6 is a diagram showing a sectional view of a semiconductor laser device in accordance with another embodiment of the present invention.

FIG. 7 is a graph illustrating plots of energy versus wave vector for free electron in a photoemission mode of the laser device shown in FIG. 6.

FIGS. 8 and 9 are diagrams showing sectional views of laser devices in accordance with further embodiments of the present invention.

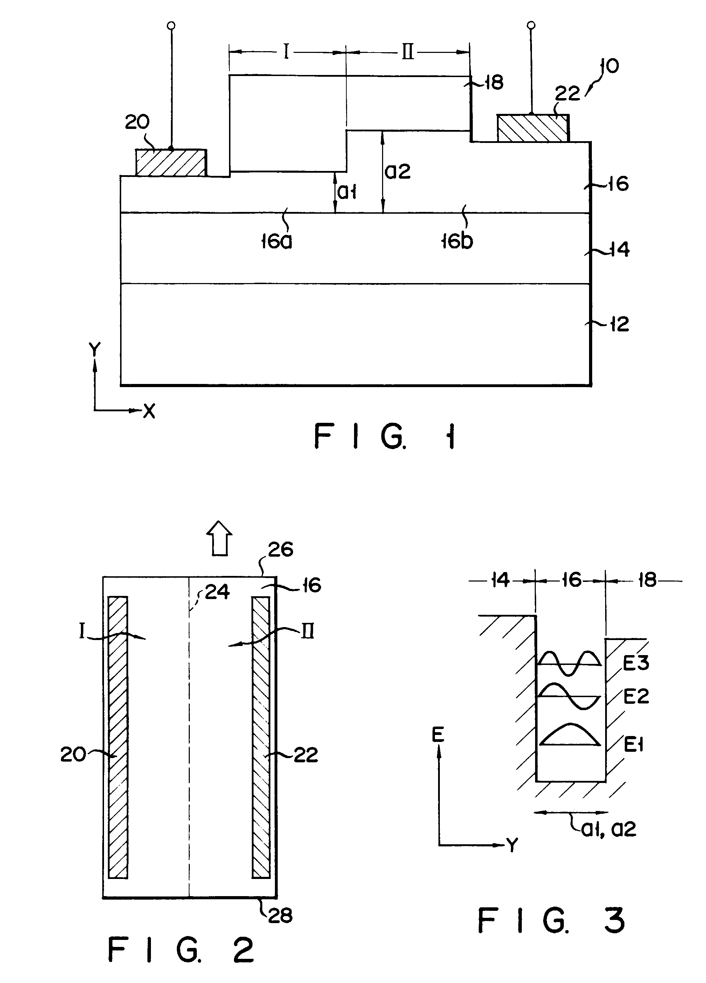

Referring now to FIG. 1 an infrared light-oscillation superlattice semiconductor laser device in accordance with one preferred embodiment of the present invention is generally designated by reference numeral "10." FIG. 1 is not drawn to scale; the sectional view has been deformed for purposes of illustration. In this drawing, an arrow X designates the horizontal direction, whereas an arrow Y indicates the vertical direction.

The laser device 10 includes a semiconductive substrate 12, such as an epitaxial layer of gallium arsenide. On the surface of substrate 10, there are arranged three semiconductive layers: a first or inter layer 14 of aluminum gallium arsenide ($A\ell_{0.3}Ga_{0.7}As$), a second or intermediate layer 16 of gallium arsenide doped with an N-type impurity to a selected concentration, and a third or outer layer 18 of aluminum gallium arsenide ($A\ell_{0.3}Ga_{0.7}As$).

As shown in FIG. 1, the inner layer 14 is uniform in thickness. The intermediate layer 16 is locally changed in thickness along the horizontal direction X, thereby to define a first region 16a and a second region 16b which is placed adjacent to the first region 16a and thicker than region 16a. The thickness of region 16a is indicated by "al," and the same of region 16b is designated by "a2." With such an arrangement, while layer 14 acts as a potential barrier layer, layer 16 functions as a quantum well layer section with well regions 16a, 16b in device 10.

The outer layer 18 covers the stepped-surface of the first and second regions 16a, 16b. The top surface of layer 18 is flat as sketched in FIG. 1. A first superlattice structure section I and a second superlattice structure section II are thus obtained which are adjacent to each other. Layer 18 serves as a second potential barrier layer.

The thickness ratio of a1 and a2 in regions 16a, 16b should be carefully determined so as to cause the ground-state potential of the quantized energy level in the first superlattice structure section I to be substantially same as the excitation energy level in the second superlattice section II. Typically, the ratio of a1 and a2 is determined as follows: a1/a2 = 1/2.

The intermediate layer 16 has exposed surface areas that are positioned on the both sides of the first and second superlattice structure sections I, II. On these exposed surfaces are arranged a couple of conductive layers 20, 22 acting as electrodes of laser 10. These electrodes 20, 22 are arranged so that they extend along the longitudinal direction of the first and second superlattice sections I, II as shown in FIG. 2. A broken line 24 shows a boundary between the two neighboring sections I, II. These sections I, II have vertical cleavage planes 26, 28 at the two opposite end portions along the longitudinal direction thereof. These cleavage planes are used as a couple of reflecting planes to define an optical resonator inside laser device 10.

The operation of laser 10 is as follows. The electrical carriers are assumed to be electrons for purposes of explanation. A bias is given between the electrodes 20, 22 in such a manner that the potential at electrode 22 is positive. Electrons are potentially attracted to move from electrode 20 toward quantum well layer 16a of the first superlattice section I, and then injected thereinto. The electrons in quantum well layer 16a are limited in their possible energy levels due to the quantum effect. In this case, the electrons are allowed to be resident at the ground-state level only. For this reason, after an electron transmigrates to quantum well layer 16b from the first superlattice section I, the current carrier must be "captured" in the excitation energy level therein. This is based on the previously described arrangement wherein the excitation level of electron energy in the second superlattice section II is substantially equal to the ground-state level in the first superlattice section I. When vacancy generates as a result of movement of electron to electrode 22 from the ground level of the second superlattice section II, another electron that have been trapped at the excited level of the second superlattice section II is now permitted to make transmission thereinto. Light is emitted at a specific wavelength corresponding to the energy gap between the excited level and the ground level in the second superlattice section II. The light emitted is then amplified by the optical resonator so that the optical intensity increases. When the intensity goes beyond a predetermined threshold level, laser oscillation takes place to produce a laser light emission, which will be sent forth externally.

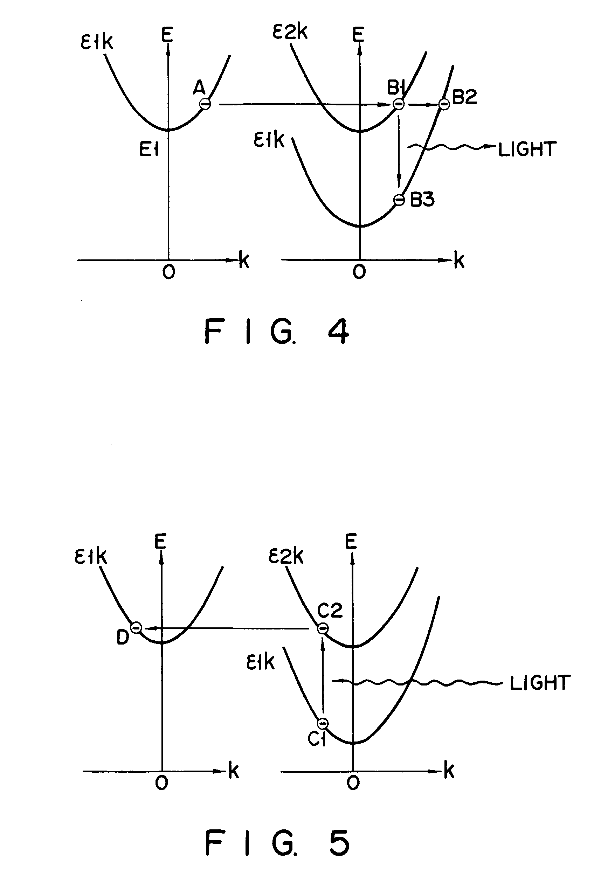

Let's discuss about the physical interaction of laser oscillation in further detail with reference to FIGS. 3 and 4. The energy band structure of electrons when looking along the direction of thickness of the embodiment device 10, i.e., the vertical direction Y, is sketched in FIG. 3, wherein some quantized energy levels E1, E2,... are defined within the quantum well layers 16a, 16b. Representing the thicknesses of these layers by a1, a2, the quantum energy levels En(I), En(II) in the first and second superlattice sections I, II may be given as follows:

$$(1) \qquad En(I) = ( \pi^2 \hbar^2/2m^*a1^2)n^2,$$

$$(2) \qquad En(II) = ( \pi^2 \hbar^2/2m^*a2^2)n^2,$$

where n is an integer.

On the other hand, the kinetic energy $\varepsilon nk(I)$ of electrons inside the the quantum well layer 16a is kept constant in the first superlattice section I. The kinetic energy $\varepsilon nk(II)$ of electrons inside the quantum well layer 16b is also kept constant in the second superlattice section II. Ignoring the kinetic energy along the direction perpendicular to the paper surface of FIG. 1, i.e., the direction Z, the kinetic energy in the first section I and the same in the second section II are given by

$$(3) \qquad \varepsilon nk(I) = En(I) + (\hbar^2/2m^*)k^2,$$

$$(4) \qquad \varepsilon nk(II) = En(II) + (\hbar^2/2m^*)k^2,$$

where k represents the wave number in the direction X.

According to the embodiment, as shown in FIG. 4, the thickness values a1 and a2 are specifically arranged so that the ground-state energy level εlk(I) in the first superlattice section I is equal to that ε2k(II) in the second section II. With such an arrangement, the electron in the state A of the second superlattice section II moves into one of the potential states B1, B2 in the second superlattice section II. The electron in the state B3 of the second superlattice section II flows into the electrode 22, thereby to create a corresponding vacancy in the state B3. This permits the electron which has resided at the state B1 in the excitation energy level of the second superlattice section II to be subjected to transition with release of energy, which leads to emission of light. The energy of light emitted will be

$$(5) \qquad \hbar\omega = 3\pi^2\hbar^2/2m^*a2^2.$$

This equation teaches us that the resultant optical energy is completely independent of the wave number k. In other words, the emitting light is constant in its wavelength. The intensity of light is substantially proportional to the value of current flowing therein.

For example, in the structure of FIG. 1, when the thicknesses of the N-type GaAs quantum well layers 16a, 16b are so designed as to be 7.5 nanometers and 15 nanometers, respectively, the optical energy of the resultant laser light was about 75 meV (the wavelength is 16.5 micrometers), which belongs to the range of far infrared radiation.

With the above embodiment, the laser oscillation is based on the intersubband transition in quantum well layers. It can thus be expected to accomplish laser oscillation that is longer in wavelength than ever before, while the optical energy is kept lowered. More importantly, the oscillation wavelength can be determined by the physical shape such as the thickness of the quantum well layer of the second superlattice structure section II, rather than the composition material thereof. This means that any desired oscillation wavelength may be attained by suitably selecting the thickness of each quantum well layer, while using the conventional semiconductor material being widely used in the art.

In the above embodiment, laser oscillation is performed utilizing the induced emission in the built-in optical resonator. Obviously, it is also possible to force the embodiment device to operate as a photodiode in a natural light emission mode. In such a case, the optical resonator is not be required.

Attention should be directed to the fact that the device 10 can also be employed as a light-sensing device or photodetector. The photodetection operation will be described with reference to FIG. 5. In the case of sensing incident light, a specific bias which is potentially reverse to that in the light-emission mode is applied between electrodes 20, 22. If no light components are introduced to device 10, current will not flow. The reason for this is that, in first superlattice section I, there is not an energy level that potentially corresponds to the ground-state level of second superlattice section II, so that any electron cannot flow into quantum well layer 16a even when an electron is injected into quantum well layer 16b of second superlattice structure section II. When light of certain energy is externally introduced to second superlattice section II, an electron in the state CI of the ground-state level εlk(II) is then excited toward the upper energy level, i.e., excitation energy level ε2k(II) as shown in FIG. 5. The electron excited in this way is now permitted to move into a corresponding state D of the ground-state level εlk(I) in first superlattice section I. In other words, it becomes possible for the electron to flow from first superlattice section I into second superlattice section II. Therefore, photodetection can be accomplished by electrically detecting current flow between electrodes 20, 22.

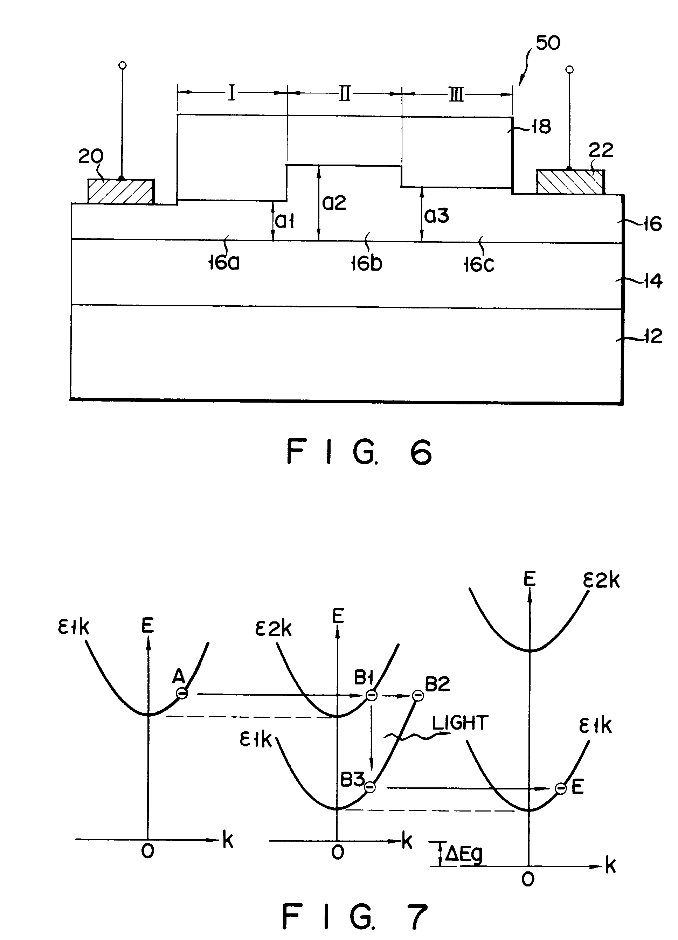

Turning now to FIG. 6, there is shown a superlattice semiconductor laser device 50 in accordance with another embodiment of the invention. The laser device 50 is similar to that shown in FIG. 1 except for the arrangement that a third superlattice structure sections III is additionally arranged therein. More specifically, the quantum well layer 16 has a specifically arranged cross-section wherein local thickness is intermediate between a1 and a2 to define a quantum well region 16c that is positioned in adjacent to the second quantum well region 16b. Preferably, the third superlattice section III is comprised of a specific semiconductive material, which is different from that of the remaining sections I, II. The thickness of layer 16 in region 16c is represented by "a3." Thickness a3 is so designed as to satisfy the following conditions: a1 < a3 < a2. The overlying barrier layer 18 covers the three superlattice sections I, II, III.

The relationship among the electron energy levels in the three superlattice sections is shown as a model in FIG. 7. It is clear from viewing the illustration of FIG. 7, that the bottom level of the conduction band in the third superlattice section III is potentially shifted by a certain value Δ Eg from that of the conduction band in the second superlattice section II. This results in that while the ground-state levels εlk(II), εlk(III) of second and third superlattice sections II, III are essentially equal to each other, the upper excitation levels ε2k(II), ε2k(III) are potentially different from each other.

The light-emitting operation of the device 50 is as follows. When a bias is applied in a similar manner as in the previously described embodiment, an electron that is present in the state A of the ground energy level in the first superlattice section I moves toward either one of the states B1, B2 of the excitation energy level of the second superlattice section II, similarly as in the previous embodiment. The third superlattice section III does not have any energy level that corresponds to the states B1 of second section II; electron transfer from the states B1, B2 to third section III is partly suppressed. Only the electron transmitted from state B1 to the ground level of second section II can move to the state E of the ground level in third section III, the state E having the same potential level as that of state B3 in second section II.

Due to the above physical interaction, the electron being present in the excitation level of the second superlattice section II is restricted in flowing directly into the third superlattice section III; it resides continuously in second section II. The current carrier density increases in second section II. This may lead to the possibility of higher density of the current carriers (electrons) being required for laser oscillation as a result of additionally providing third superlattice section III which contributes to the carrier confinement effect in second section II. Therefore, using a similar optical resonator to that in the aforesaid embodiment will result in a laser device being lowered in threshold level and yet enhanced in the oscillation efficiency thereof. It is similar to the previous embodiment that the device 50 may be used also as a photosensitive diode without adding any substantial modifications thereto.

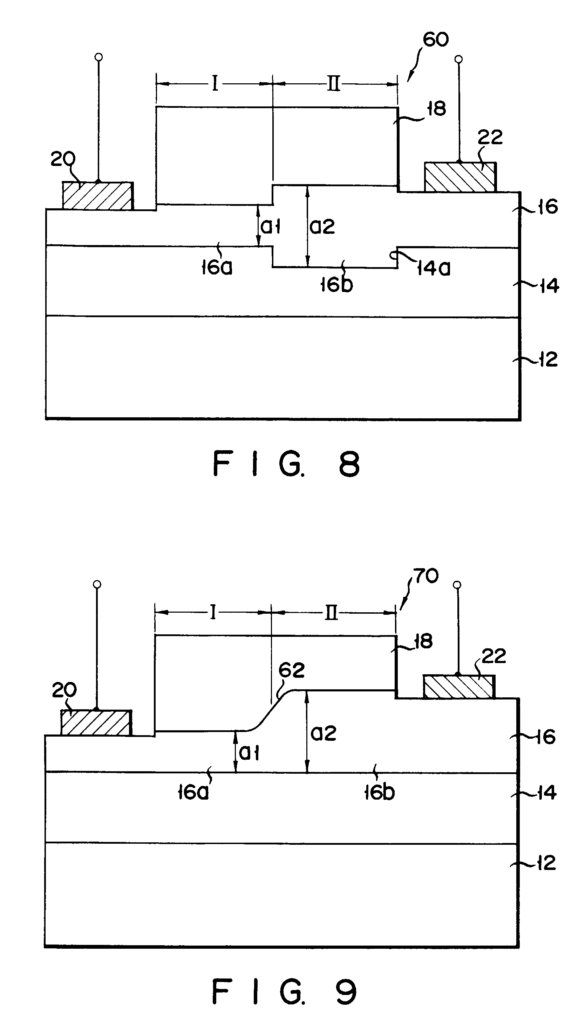

Another semiconductor laser device 60 is shown in FIG. 8, wherein laser 60 differs from that shown in FIG. 1 in that first barrier layer 14 has an elongated concave portion 14a in a region corresponding to the second superlattice structure section II, and that the difference in height between quantum well layers 16a, 16b is decreased so that the thickness ratio of a1 and a2 is kept unchanged. With such an arrangement, similar technical advantages may be attained.

A still another semiconductor laser device 70 is shown in FIG. 9, wherein laser 70 is similar to that shown in FIG. 1 with the intermediate layer 16 being modified to have a moderately slanted surface configuration 62 in the boundary of the first and second superlattice structure sections I and II.

The present invention is not limited to the above-described specific embodiments and may be practiced or embodied in still other ways.

Although the gallium arsenide/aluminum gallium arsenide-based materials are used in the above embodiments, other kinds of materials may be employed if desired. For example, if more power is needed for the laser oscillation, an insulative material having greater energy band gap such as $SiO_2$ may be used as the potential barrier layer, thereby to cause the well of potential of quantum well layer to be deeper. Silicon is employed for the quantum well layer. In this case, the potential depth of the quantum well layer increases up to 3 eV, or more. Our experiment has demonstrated that, if the quantum well layer thicknesses a1, a2 in the first and second superlattice structure sections I, II are 1.5 nanometers and 3 nanometers, respectively, the optical intensity of photoemission or photodetection was measured to be 0.63 eV. The material is same as that in the existing solid-state IC devices, the manufacturing technology of which has been already established. The above exemplary modification will suggest the possibility of easier optoelectrical integrated circuit devices using silicon only.

## Claims

1.  An optical device (10, 50, 60, 70) having a substrate (12), comprising a quantum well layer (16) arranged on said substrate (12), said device including both a first section (I) having a first region (16a) of said quantum well layer (16) and also a second section (II) arranged adjacent to said first section and having a second region (16b) of said quantum well layer (16), which second region (16b) is different in physical shape from first region (16a) and bias means (20, 22) comprising first and second electrodes for applying a bias between said first and second sections (I, II), characterised in that said difference in physical shape being such that the ground-state level of one of the first and second sections (I, II) is substantially equal to an excitation level of the other of said first and second sections (I, II), and the first and second electrodes of said bias means (20, 22) are respectively formed on said first region (16a) and said second region (16b), respectively, to cause transfer of carriers between the first and second sections (16a, 16b) within said quantum well layer (16), thereby to effect emission or detection of light.

2.  A device according to claim 1, further characterised in that the first and second regions (16a, 16b) differ in thickness from each other.

3.  A device according to claim 2, further characterised in that the second section (II) is greater in thickness than the first section (I), and the thickness of each of said first and second sections is determined so that the ground-state level in said first section is equal to the excitation level of said second section.

4.  A device according to claim 3, further characterised by further comprising a third section (III) arranged adjacent to said second region (16b) which has an intermediate thickness between those of first and second sections (I, II).

5.  A device according to claim 4, further characterised in that said thickness of the third section is determined so as to cause a ground-state level in one of the first and second sections to be substantially equal to an excitation level of the other of said first and second sections, and to cause an excitation level in said third section to be potentially greater than that of said the other of said first and second sections.

**6.** A device according to claim 5, further characterised in that said third section is different in material from said first and second sections.

**7.** A device according to claim 1, further characterised by comprising a first layer (14) and a third layer (18) being of predetermined semiconductive material which are separated by a second layer (16) including said first and second sections sandwiched between said first and third layers, said third layer overlying said first and second regions.

**8.** A device according to claim 7, further characterised in that said third layer (18) has an elongated shape on said substrate (12), while allowing the underlying second layer to have exposed surfaces on the both sides of said third layer.

**9.** A device according to claim 8, further characterised in that said first layer and said third layer comprise aluminium gallium arsenide compound.

**10.** A device according to claim 9, further characterised in that said second layer comprises gallium arsenide of a selected type of conductivity.

**11.** A device according to claim 8 or 10, further characterised in that said cross-section area is a step-shaped profile.

**12.** A device according to claim 11, further characterised by further comprising a couple of electrodes (20, 22) on the exposed surfaces of said second layer, said electrodes longitudinally extending in parallel with said third layer.

**13.** A device according to claim 12, further characterised in that said third layer has two opposite end portions (26, 28) serving as reflection planes for providing an optical resonator.

**14.** A device according to claim 11, further characterised in that said second layer has a slanted surface portion (62) in a boundary between said first and second sections (I, II).

**15.** A device according to claim 1, further characterised in that each of said first and second sections are constituted by a superlattice structure including a plurality of stacked quantum wells and barrier layers.

**Patentansprüche**

**1.** Optische Vorrichtung (10, 50, 60, 70) mit einem Substrat (12), umfassend eine auf dem Substrat (12) angeordnete Quantensenken- oder Quanten-Well- bzw. Potentialtopfschicht (16), welche Vorrichtung sowohl eine erste Sektion (I) mit einer ersten Zone (16a) der Quanten-Well-Schicht (16) als auch eine neben der ersten Sektion angeordnete zweite Sektion (II) mit einer zweiten Zone (16b) der Quanten-Well-Schicht (16), welche zweite Zone (16b) in der physikalischen bzw. körperlichen Form von der ersten Zone (16a) verschieden ist, und eine Vorspannungseinheit (20, 22) mit ersten und zweiten Elektroden zum Anlegen einer Vorspannung zwischen den ersten und zweiten Sektionen (I, II) aufweist,
dadurch gekennzeichnet,
daß der Unterschied in der physikalischen bzw. körperlichen Form derart ist, daß der/das Grundzustandspegel bzw. -niveau einer der ersten und zweiten Sektionen (I, II) praktisch gleich einem Anregungspegel bzw. -niveau der anderen der ersten und zweiten Sektionen (I, II) ist, und die ersten und zweiten Elektroden der Vorspannungseinheit (20, 22) jeweils auf der ersten Zone (16a) bzw. der zweiten Zone (16b) geformt sind, um eine(n) Übertragung oder Transfer von Ladungsträgern zwischen den ersten und zweiten Sektionen bzw. Zonen (16a, 16b) in der Quanten-Well-Schicht (16) herbeizuführen und dadurch Emission oder Detektion von Licht zu bewirken.

**2.** Vorrichtung nach Anspruch 1, dadurch gekennzeichnet, daß die ersten und zweiten zonen (16a, 16b) in ihrer Dicke voneinander verschieden sind.

**3.** Vorrichtung nach Anspruch 2, dadurch gekennzeichnet, daß die zweite Sektion (II) eine größere Dicke als die erste Sektion (I) aufweist und die Dikke jeder der ersten und zweiten Sektionen so bestimmt ist, daß der Grundzustandspegel in der ersten Sektion dem Anregungspegel der zweiten Sektion gleich ist.

**4.** Vorrichtung nach Anspruch 3, ferner gekennzeichnet durch eine neben der zweiten Zone (16b) angeordnete dritte Sektion (III) mit einer Dicke zwischen den Dicken der ersten und zweiten Sektionen (I, II).

**5.** Vorrichtung nach Anspruch 4, dadurch gekennzeichnet, daß die Dicke der dritten Sektion so bestimmt ist, daß ein Grundzustandspegel in einer der ersten und zweiten Sektionen praktisch einem Anregungspegel der anderen der ersten und zweiten Sektionen gleich wird. und ein Anregungspegel in der dritten Sektion potentiell (oder potentialmäßig) größer wird als derjenige der anderen der ersten und zweiten Sektionen.

**6.** Vorrichtung nach Anspruch 5, dadurch gekennzeichnet, daß die dritte Sektion bezüglich des Werkstoffs von erster und zweiter Sektion verschieden ist.

7. Vorrichtung nach Anspruch 1, ferner gekennzeichnet durch eine erste Schicht (14) und eine dritte Schicht (18) aus vorbestimmtem Halbleitermaterial, die durch eine zweite Schicht (16) getrennt sind, welche die ersten und zweiten Sektionen enthält und zwischen die ersten und zweiten Schichten eingefügt ist, welche dritte Schicht über den ersten und zweiten Zonen liegt.

8. Vorrichtung nach Anspruch 7, dadurch gekennzeichnet, daß die dritte Schicht (18) eine langgestreckte Form auf dem Substrat (12) aufweist, dabei aber zuläßt, daß die darunterliegende zweite Schicht an den beiden Seiten der dritten Schicht freiliegende Oberflächen aufweist.

9. Vorrichtung nach Anspruch 8, dadurch gekennzeichnet, daß erste und dritte Schicht aus Aluminium-Gallium-Arsenid-Verbindung bestehen.

10. Vorrichtung nach Anspruch 9, dadurch gekennzeichnet, daß die zweite Schicht aus Gallium-Arsenid eines ausgewählten Leitfähigkeits- bzw. Leitungstyps besteht.

11. Vorrichtung nach Anspruch 8 oder 10, dadurch gekennzeichnet, daß die Querschnittsfläche ein stufenförmiges Profil ist.

12. Vorrichtung nach Anspruch 11, ferner gekennzeichnet durch ein Paar von Elektroden (20, 22) auf den freiliegenden Oberflächen der zweiten Schicht, welche Elektroden in Längsrichtung parallel zur dritten Schicht verlaufen.

13. Vorrichtung nach Anspruch 12, dadurch gekennzeichnet, daß die dritte Schicht zwei gegenüberliegende Endbereiche (26, 28) aufweist, die als Reflexionsebenen oder -flächen zur Bereitstellung eines optischen Resonators dienen.

14. Vorrichtung nach Anspruch 11, dadurch gekennzeichnet, daß die zweite Schicht einen schrägen Oberflächenbereich (62) in einem Grenzbereich zwischen den ersten und zweiten Sektionen (I, II) aufweist.

15. Vorrichtung nach Anspruch 1, dadurch gekennzeichnet, daß jede der ersten und zweiten Sektionen durch ein Überstrukturgitter mit einer Anzahl von gestapelten Quanten-Wells bzw. Potentialtöpfen und Sperrschichtcr gebildet ist.

**Revendications**

1. Dispositif optique (10, 50, 60, 70) comportant un substrat (12) comprenant une couche à puits quantiques (16) agencée sur ledit substrat (12), ledit dispositif comprenant à la fois un première section (I) comportant une première région (16a) de ladite couche à puits quantiques (16) et, également, une seconde section (II) agencée contiguë à ladite première section et comportant une seconde région (16b) de ladite couche à puits quantiques (16), laquelle seconde région (16b) est de forme physique différente de celle de la première région (16a), et des moyens de polarisation (20, 22) comprenant des première et seconde électrodes pour appliquer une polarisation entre lesdites première et seconde sections (I, II), caractérisé en ce que ladite différence de forme physique est telle que le niveau d'état normal d'énergie de l'une des première et seconde sections (I, II) est sensiblement égal à un niveau d'excitation de l'autre desdites première et seconde sections (I, II), et en ce que les première et seconde électrodes desdits moyens de polarisation (20, 22) sont respectivement formées sur ladite première région (16a) et ladite seconde région (16b), respectivement, pour entraîner le transfert de porteurs entre les première et seconde sections (16a, 16b) à l'intérieur de ladite couche à puits quantiques (16), pour effectuer de ce fait une émission ou une détection de lumière.

2. Dispositif selon la revendication 1, caractérisé, de plus, en ce que les première et seconde régions (16a, 16b) sont d'épaisseur différente l'une de l'autre.

3. Dispositif selon la revendication 2, caractérisé, de plus, en ce que l'épaisseur de la seconde section (II) est plus grande que celle de la première section (I) et en ce que l'épaisseur de chacune des première et seconde sections est déterminée de sorte que le niveau d'état normal d'énergie dans ladite première section soit égal au niveau d'excitation de ladite seconde section.

4. Dispositif selon la revendication 3, caractérisé, de plus, en ce qu'il comprend, de plus, une troisième section (III) agencée contiguë à ladite seconde région (16b) qui présente une épaisseur intermédiaire entre celles des première et seconde sections (I, II).

5. Dispositif selon la revendication 4, caractérisé, de plus, en ce que ladite épaisseur de la troisième section est déterminée de manière à ce qu'un niveau d'état normal d'énergie dans l'une des première et seconde sections soit sensiblement égal à un niveau d'excitation de l'autre des première et seconde sections et de manière à ce qu'un niveau d'excitation dans ladite troisième section soit plus grand potentiellement que celui de ladite autre des première et seconde sections.

6. Dispositif selon la revendication 5, caractérisé, de plus, en ce que ladite troisième section est d'un matériau différent de celui desdites première et seconde sections.

7. Dispositif selon la revendication 1, caractérisé, de plus, en ce qu'il comprend une première couche (14) et une troisième couche (18) d'un matériau semi-conducteur prédéterminé, qui sont séparées par une seconde couche (16) comprenant lesdites première et seconde sections, intercalée entre lesdites première et troisième couches, ladite troisième couche recouvrant lesdites première et seconde régions.

8. Dispositif selon la revendication 7, caractérisé, de plus, en ce que ladite troisième couche (18) présente une forme allongée sur ledit substrat (12), tout en permettant à la seconde couche de recouvrement d'avoir des surfaces exposées sur les deux côtés de ladite troisième couche.

9. Dispositif selon la revendication 8, caractérisé, de plus, en ce que ladite première couche et ladite troisième couche comprennent un composé d'arséniure d'aluminium et de gallium.

10. Dispositif selon la revendication 9, caractérisé, de plus, en ce que ladite seconde couche comprend de l'arséniure de gallium d'un type de conductivité choisi.

11. Dispositif selon la revendication 8 ou 10, caractérisé, de plus, en ce que la zone en coupe est un profile de forme étagée.

12. Dispositif selon la revendication 11, caractérisé, de plus, en ce qu'il comprend, de plus, deux électrodes (20, 22) sur les surfaces exposées de ladite seconde couche, lesdites électrodes s'étendant longitudinalement parallèles à ladite troisième couche.

13. Dispositif selon la revendication 12, caractérisé, de plus, en ce que ladite troisième couche comporte deux parties d'extrémité opposées (26, 28) servant de plans de réflexion pour créer un résonateur optique.

14. Dispositif selon la revendication 11, caractérisé, de plus, en ce que ladite seconde couche comporte une partie de surface en pente (62) à une limite entre lesdites première et seconde sections (I, II).

15. Dispositif selon la revendication 1, caractérisé, de plus, en ce que chacune desdites première et seconde sections est constituée d'une surstructure comprenant une pluralité de puits quantiques et de couches de barrière empilés.

FIG. 1

FIG. 2

FIG. 3

F I G. 4

F I G. 5

F I G. 6

F I G. 7

F I G. 8

F I G. 9